# EUROPÄISCHE PATENTSCHRIFT

(11) **EP 1 516 372 B1**
(45) Veröffentlichungstag und Bekanntmachung des Hinweises auf die Patenterteilung: **03.01.2007**
(21) Anmeldenummer: 03761408.8
(22) Anmeldetag: 04.06.2003
(51) Int. Cl.: H01L 33/00, H01L 31/02, H01L 23/495

(54) **OBERFLÄCHENMONTIERBARE LUMINESZENZ- UND/ODER PHOTO-DIODE UND VERFAHREN ZU DEREN HERSTELLUNG**
SURFACE-MOUNTABLE LIGHT-EMITTING DIODE AND/OR PHOTODIODE AND METHOD FOR THE PRODUCTION THEREOF
DIODE LUMINESCENTE ET/OU PHOTODIODE MONTEE EN SURFACE ET PROCEDE DE FABRICATION ASSOCIE

(30) Priorität: 26.06.2002 DE 10228634
(43) Veröffentlichungstag der Anmeldung: 23.03.2005
(73) Patentinhaber: Osram Opto Semiconductors GmbH, 93049 Regensburg (DE)
(72) Erfinder: SORG, Jörg, 93053 Regensburg (DE); BOGNER, Georg, 93138 Lappersdorf (DE); WAITL, Günter, 93049 Regensburg (DE); BRUNNER, Reinhold, 93199 Zell (DE)
(74) Vertreter: Epping - Hermann - Fischer
(86) Internationale Anmeldenummer: PCT/DE2003/001831
(87) Internationale Veröffentlichungsnummer: WO 2004/004017

(56) Entgegenhaltungen:
- EP-A- 1 162 669
- WO-A-02/17405
- US-B1- 6 184 544
- PATENT ABSTRACTS OF JAPAN vol. 1997, no. 02, 28. Februar 1997 (1997-02-28) -& JP 08 264841 A (MATSUSHITA ELECTRON), 11. Oktober 1996 (1996-10-11)
- PATENT ABSTRACTS OF JAPAN vol. 008, no. 226 (E-272), 17. Oktober 1984 (1984-10-17) -& JP 59 107584 A (CASIO KEISANKI KK), 21. Juni 1984 (1984-06-21)
- PATENT ABSTRACTS OF JAPAN vol. 1997, no. 03, 31. März 1997 (1997-03-31) & JP 08 298345 A (SHICHIZUN DENSHI), 12. November 1996 (1996-11-12)
- PATENT ABSTRACTS OF JAPAN vol. 1995, no. 11, 26. Dezember 1995 (1995-12-26) -& JP 07 220972 A (TEIKOKU TSUSHIN KOGYO), 18. August 1995 (1995-08-18)
- PATENT ABSTRACTS OF JAPAN vol. 1995, no. 04, 31. Mai 1995 (1995-05-31) & JP 07 022653 A (MITSUBISHI CABLE IND), 24. Januar 1995 (1995-01-24)
- PATENT ABSTRACTS OF JAPAN vol. 008, no. 036 (E-227), 16. Februar 1984 (1984-02-16) & JP 58 194383 A (SUMITOMO DENKI KOGYO), 12. November 1983 (1983-11-12)

## Beschreibung

Die Erfindung betrifft eine oberflächenmontierbare Lumineszenz- und/oder Photodiode mit einem Chipgehäuse, das einen Leiterrahmen (Leadframe) aufweist und einem auf dem Leiterrahmen angeordneten und mit diesem in elektrischen Kontakt stehenden Halbleiterchip, der einen aktiven, strahlungsemittierenden Bereich enthält. Die Erfindung betrifft auch ein Verfahren zur Herstellung einer derartigen Lumineszenzdiode.

Eine Lumineszenzdiode (LED) mit einem Leiterrahmen, der eine Kunststofffolie und eine Metallfolie enthält, ist zum Beispiel aus der Druckschrift JP 59 107584 A bekannt. Bei der in dieser Druckschrift dargestellten Lumineszenzdiode ist ein Halbleiterchip in einer Ausnehmung der Kunststofffolie auf einem ersten Teilbereich der Metallfolie angeordnet. Mittels eines Bonddrahts ist der Halbleiterchip mit einem in der gleichen Ausnehmung der Kunststofffolie angeordnetem zweiten Teilbereich der Metallfolie verbunden.

Zur Erweiterung der Einsatzgebiete und zur Reduzierung der Herstellungskosten wird versucht, Lumineszenz- und/oder Photodioden in immer kleineren Baugrößen herzustellen. Sehr kleine Lumineszenzdioden sind beispielsweise für die Hintergrundbeleuchtung der Tasten von Mobiltelefonen erforderlich.

Inzwischen sind LED-Gehäuse mit einer Stellfläche der Abmessung 0402 (entsprechend 0,5 mm x 1,0 mm) und einer Bauteilhöhe von 400 µm - 600 µm verfügbar. Eine weitere Verminderung der Bauteilhöhe gestaltet sich mit den gegenwärtigen Gehäusekonzepten jedoch schwierig.

Der vorliegenden Erfindung liegt die Aufgabe zugrunde, eine oberflächenmontierbare Lumineszenz- und/oder Photodiode der eingangs genannten Art zu schaffen, die eine weitergehende Verkleinerung ihrer Baugröße erlaubt.

Diese Aufgabe wird durch eine oberflächenmontierbare Lumineszenz- und/oder Photo-Diode mit den Merkmalen des Anspruches 1 und das Verfahren zur Herstellung einer oberflächenmontierbaren Lumineszenz- und/oder Photo-Diode mit den Merkmalen des Anspruches 7 gelöst. Vorteilhafte Weiterbildungen und Ausgestaltungen der Erfindung gehen aus den Unteransprüchen hervor.

Erfindungsgemäß ist bei einer gattungsgemäßen oberflächenmontierbaren Lumineszenz- und/oder Photo-Diode vorgesehen, daß der Leiterrahmen durch eine biegsame Mehrlagenschicht gebildet ist. Durch Montage des strahlungserzeugenden und/oder strahlungsempfangenden Halbleiterchips auf einem biegsamen Leiterrahmen wird eine Lumineszenz- und/oder Photo-Diode mit kleiner Stellfläche geschaffen, die in hoher Packungsdichte und somit mit geringen Produktionskosten hergestellt werden kann.

Weiterhin ist vorgesehen, daß die biegsame Mehrlagenschicht eine Metallfolie und eine auf der Metallfolie angeordnete und mit dieser verbundene Kunststofffolie umfaßt.

Dabei ist zweckmäßig die Kunststofffolie mit der Metallfolie verklebt. Die beiden miteinander verbundenen Folien stellen somit einen flexiblen Leiterrahmen für den Halbleiterchip dar.

Die Metallfolie umfaßt einen ersten und einen zweiten Chipanschlußbereich, und die Kunststofffolie weist in den auf diesen Chipanschlußbereichen angeordneten Bereichen Aussparungen auf. Der Halbleiterchip ist mit einer ersten Kontaktfläche auf dem ersten Chipanschlußbereich angeordnet, und mit einer zweiten Kontaktfläche mit dem zweiten Chipanschlußbereich mittels eines Bonddrahts elektrisch leitend verbunden. Das bedeutet, dass der Halbleiterchip durch eine erste Aussparung hindurch auf dem ersten Chipanschlußbereich montiert ist und die elektrische Verbindung der zweiten Kontaktfläche mit dem zweiten Chipanschlußbereich durch eine zweite Aussparung hindurch hergestellt ist.

Die Dicke der Metallfolie beträgt in einer bevorzugten Ausgestaltung der Erfindung weniger als 80 µm und liegt bevorzugt zwischen einschließlich 30 µm und einschließlich 60 µm. Eine solche minimale Metallisierungsdicke erlaubt die Realisierung einer sehr geringen Gehäusehöhe von weniger als 400 µm, insbesondere von weniger als 350 µm. Vorteilhafterweise kann diese Bauhöhe auch mit einer Chiphöhe von 150 µm realisiert werden, ohne dass gleichzeitig der Bogen eines Bonddrahtes zwischen der zweiten Kontaktfläche des Chips und dem zweiten Chipanschlußbereich wesentlich kleiner gestaltet werden muß. Selbstverständlich können mit der vorliegenden Bauform auch mit herkömmlich standardmäßigen Chipdicken von zwischen 220 µm und 250 µm besonders geringe Bauhöhen erzielt werden.

Die Kunststofffolie ist in einer bevorzugten Ausführungsform durch eine Epoxidharz-Folie gebildet. In diesem Zusammenhang ist es weiterhin bevorzugt, wenn die Kunststofffolie eine Dicke von weniger als 80 µm, bevorzugt eine Dicke zwischen einschließlich 30 µm und einschließlich 60 µm aufweist.

In einer zweckmäßigen Weiterbildung der Erfindung ist vorgesehen, daß der Halbleiterchip in eine transparente oder transluzente Spritzgußmasse eingebettet ist. An Stelle der Spritzgußmasse kann eine Spritzpressmasse verwendet sein.

Besonders große Vorteile bietet die Erfindung für Miniatur-Lumineszenzdioden bei denen der Leiterrahmen eine Abmessung von etwa 0,5 mm x 1,0 mm oder weniger aufweist, insbesondere bei Lumineszenzdioden, die eine Bauteilhöhe von etwa 400 µm oder weniger, bevorzugt von etwa 350 µm oder weniger aufweisen.

Neben den genannten Vorteilen bieten Lumineszenzdioden der oben beschriebenen Art einen geringen Wärmewiderstand Rₜₕ, so daß aufgrund der guten Wärmeabführung eine hohe Verlustleistung möglich ist. Auch erlaubt der geschilderte Aufbau, auf engem Raum sehr flexibel Gestaltungen mit einer Mehrzahl von Chips (Multi Chip Designs) zu verwirklichen.

Das Verfahren zur Herstellung einer oberflächenmontierbaren Lumineszenzdiode umfaßt erfindungsgemäß die Verfahrensschritte:
- Bereitstellen eines Leiterrahmens aus einer biegsamen Mehrlagenschicht, die eine Metallfolie und eine auf der Metallfolie angeordnete und mit dieser verbundene Kunststofffolie umfaßt, wobei die Metallfolie einen ersten und einen zweiten Chipanschlußbereich umfaßt und die Kunststofffolie in den auf diesen Chipanschlußbereichen angeordneten Bereichen Aussparungen aufweist;
- Bereitstellen eines Halbleiterchips, der einen aktiven, strahlungsemittierenden Bereich enthält und eine erste und zweite Kontaktfläche aufweist;
- Montieren des Halbleiterchips mit der ersten Kontaktfläche auf den ersten Chipanschlußbereich in der ersten Aussparung der Kunststofffolie des Leiterrahmens;
- Verbinden der zweiten Kontaktfläche mit dem zweiten Chipanschlußbereich des Leiterrahmens mittels eines Bondrahts, der durch die auf dem zweiten Chipanschlussbereich angeordnete zweite Aussparung der Kunststofffolie zum zweiten Chipanschlusßbereich geführt ist; und
- Herstellen einer Umhüllung für den Halbleiterchip mittels Vergießen, Umspritzen oder Umpressen (im Folgenden zusammenfassend "Umhüllen" genannt) des Halbleiterchips mit Umhüllungsmaterial, das für die emittierte und/oder empfangene Strahlung durchlässig ist, insbesondere mit entsprechend transparentem oder transluzentem Kunststoffmaterial.

In einer bevorzugten Ausgestaltung umfaßt dabei der Schritt des Bereitstellens eines Leiterrahmens das Bereitstellen und Stanzen einer dünnen Metallfolie, um den ersten und zweiten Chipanschlußbereich zu definieren.

In einer weiteren zweckmäßigen Ausgestaltung umfaßt der Schritt des Bereitstellens eines Leiterrahmens das Bereitstellen und Stanzen einer dünnen Kunststofffolie, um Aussparungen zum elektrischen Anschluß des Halbleiterchips zu definieren.

Die beiden Folien werden dann vorteilhaft bei dem Schritt des Bereitstellens eines Leiterrahmens miteinander verklebt.
In vorstehendem Zusammenhang ist es weiter zweckmäßig, wenn bei dem Schritt des Umhüllens das Umhüllungsmaterial auf die Kunststofffolie der Mehrlagenschicht gespritzt wird. Dies sichert eine gute Anbindung des Umhüllungskörpers an den flexiblen Leiterrahmen.

Weiter wird bei dem Schritt des Umhüllens mit Vorteil ein Anspritzkanal durch eine Mehrzahl von auf der Mehrlagenschicht angeordneten Bausteinen geführt. Dadurch wird, verglichen mit dem standardmäßigen Anspritzen jedes Bauteils durch einen eigenen Kanal, die Zahl der Anspritzkanäle reduziert, so daß eine Vielzahl von Bauelementen auf engstem Raum realisiert werden kann.

In einer bevorzugten Gestaltung des erfindungsgemäßen Verfahrens werden der erste und zweite Chipanschlußbereich des Leiterrahmens bei den Schritten des Montierens des Halbleiterchips, des Verbindens der zweiten Kontaktfläche und des Umhüllens des Halbleiterchips kurzgeschlossen und geerdet. Dadurch werden statische Aufladungen verhindert und Schäden durch elektrostatische Entladungen (ESD) an den Bauteilen vermieden.

Weiter ist es bei dem erfindungsgemäßen Verfahren bevorzugt, wenn eine Mehrzahl von auf der Mehrlagenschicht angeordneten Bausteinen nach dem Schritt des Umhüllens auf Funktionsfähigkeit getestet werden. Dazu werden die einzelnen Bausteine bei Erhalt ihrer mechanischen Einbindung elektrisch getrennt.

Durch die Verwendung des flexiblen Leiterrahmenmaterials können alle Prozeßschritte des erfindungsgemäßen Verfahrens Reel-to-Reel (von einer Abwickel- zu einer Aufwickelhaspel) durchgeführt werden, was den Handhabungsaufwand bei der Herstellung minimiert.

Darüber hinaus besteht bei dem beschriebenen Konzept die Möglichkeit, auf das Taping der Bauteile zu verzichten. Falls gewünscht, kann eine Mehrzahl zusammengehöriger Bauteile nach einem Chiptest auf dem flexiblen Rahmen zusammen mit einer Wafermap ausgeliefert werden. Alternativ können die Bauteile nach dem Chiptest wie bisher vereinzelt, getaped und ausgeliefert werden.

Weitere vorteilhafte Ausgestaltungen, Merkmale und Details der Erfindung ergeben sich aus den abhängigen Ansprüchen, der Beschreibung des Ausführungsbeispiels und der Zeichnungen.

Weitere Vorteile, Weiterbildungen und Ausgestaltungen der erfindungsgemäßen Lumineszenz- und/oder Photo-Diode ergeben sich aus dem im Folgenden in Verbindung mit der Zeichnung erläuterten Ausführungsbeispiel. In der Zeichnung sind jeweils nur die für das Verständnis der Erfindung wesentlichen Elemente dargestellt. Dabei zeigt
- Figur 1: eine schematische Schnittansicht des Ausführungsbeispieles; und
- Figur 2: eine perspektivische Ansicht des Ausführungsbeispieles von Fig. 1 in Explosionsdarstellung.

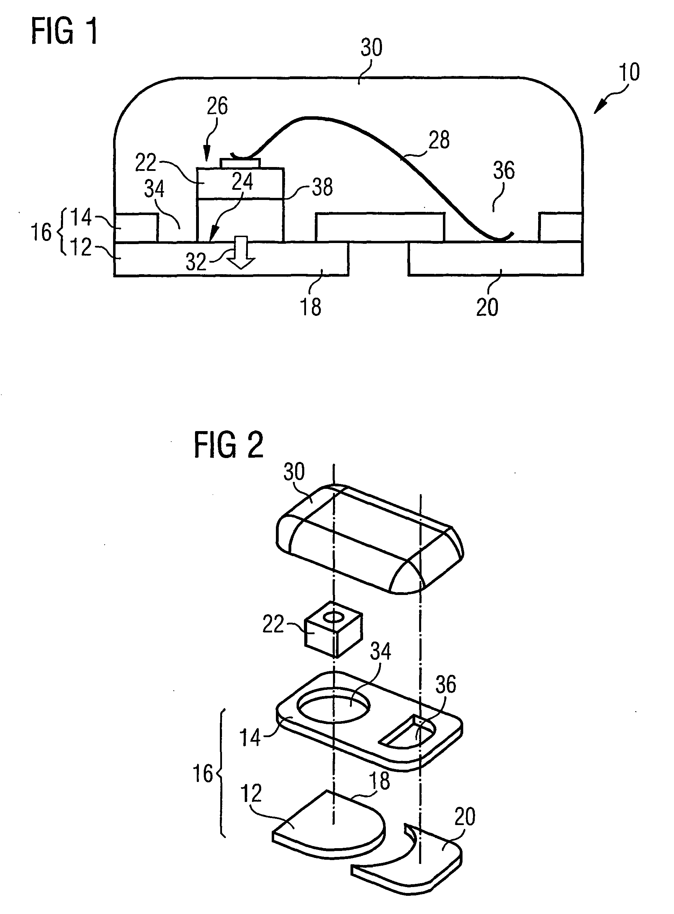

Figuren 1 und 2 zeigen in schematischer Darstellung eine allgemein mit 10 bezeichnete oberflächenmontierbare Lumineszenzdiode.

Die Lumineszenzdiode 10 weist einen flexiblen Leiterrahmen 16, einen LED-Chip 22 mit einem aktiven, strahlungsemittierenden Bereich 38 und einen Umhüllungskörper 30 auf. Der flexible Leiterrahmen 16 besteht dabei aus einer 60 µm dicken Metallfolie 12 und einer ebenfalls 60 µm dicken Epoxidharzfolie 14, die hochgenau miteinander verklebt sind.

Die Metallfolie 12 ist so gestanzt, daß sie eine Kathode 18 und eine Anode 20 definiert. Jeweils über Kathode und Anode sind Aussparungen 34 und 36 in die Kunststofffolie 14 gestanzt. Der LED-Chip 22 ist mit seiner Unterseite 24 durch die Aussparung 34 hindurch auf die Kathode 18 gebondet. Die Anode 20 ist über einen Bonddraht 28 durch die Aussparung 36 mit der Oberseite 26 des LED-Chips 22 verbunden.

Um auf dem flexiblen Rahmen möglichst viele Bauteile realisieren zu können, wird zum Umhüllen beispielsweise das sogenannte Cavity-to-Cavity Molding eingesetzt. Dabei wird durch die Führung eines Anspritzkanals durch die Bauteile die Anzahl der Anspritzkanäle reduziert.

Bei Betrieb der Lumineszenzdiode erzeugte Verlustwärme wird effektiv über die Metallfolie 12 abgeführt (Bezugszeichen 32).

Insgesamt hat die Lumineszenzdiode 10 eine Stellfläche (footprint) von etwa 0,5 mm x 1,0 mm und weist eine gesamte Bauteilhöhe von lediglich 350 µm auf. An Stelle des Lumineszenzdiodenchips kann ein Photodiodenchip eingesetzt sein oder ein Chip der als Lumineszenzdiode und als Photo-Diode betrieben wird.

## Patentansprüche

1. Oberflächenmontierbare Lumineszenz- und/oder Photo-Diode mit einem Chipgehäuse, das einen Leiterrahmen (16) aufweist, wobei der Leiterrahmen (16) durch eine biegsame Mehrlagenschicht (12, 14), die eine Metallfolie (12) und eine auf der Metallfolie angeordnete und mit dieser verbundene Kunststofffolie (14) umfaßt, gebildet ist,
und einem auf dem Leiterrahmen (16) angeordneten und mit diesem in elektrischem Kontakt stehenden Halbleiterchip (22), der einen aktiven, strahlungsemittierenden und/oder strahlungsempfangenden Bereich enthält, wobei
- die Metallfolie (12) einen ersten und einen zweiten Chipanschlußbereich (18, 20) umfaßt, **dadurch gekennzeichnet, daß** die Kunststofffolie in den auf diesen Chipanschlußbereichen (18, 20) angeordneten Bereichen Aussparungen (34, 36) aufweist, und
- der Halbleiterchip (22) mit einer ersten Kontaktfläche (24) in einer ersten Aussparung (34) der Kunststofffolie (14) auf dem ersten Chipanschlußbereich (18) angeordnet ist, und mit einer zweiten Kontaktfläche (26) mittels eines Bondrahts (28), der durch die auf dem zweiten Chipanschlußbereich (20) angeordnete zweite Aussparung (36) der Kunststofffolie (14) zum zweiten Chipanschlußbereich (20) geführt ist, mit dem zweiten Chipanschlußbereich (20) verbunden ist.

2. Oberflächenmontierbare Lumineszenz- und/oder Photo-Diode nach Anspruch 1,
**dadurch gekennzeichnet , daß**
die Kunststofffolie (14) mit der Metallfolie (12) verklebt ist.

3. Oberflächenmontierbare Lumineszenz- und/oder Photo-Diode nach Anspruch 1 oder 2,
**dadurch gekennzeichnet , daß**
die Dicke der Metallfolie (12) zwischen einschließlich 30 µm und einschließlich 60 µm liegt.

4. Oberflächenmontierbare Lumineszenz- und/oder Photo-Diode nach einem der vorhergehenden Ansprüche,
**dadurch gekennzeichnet, daß**
die Kunststofffolie durch eine Epoxidharz-Folie (14) gebildet ist.

5. Oberflächenmontierbare Lumineszenz- und/oder Photo-Diode nach einem der vorhergehenden Ansprüche,
**dadurch gekennzeichnet, daß**
die Dicke der Kunststofffolie (14)
zwischen einschließlich 30 µm und einschließlich 60 µm liegt.

6. Oberflächenmontierbare Lumineszenz- und/oder Photo-Diode nach einem der vorhergehenden Ansprüche,
**dadurch gekennzeichnet, daß**
der Halbleiterchip (22) in eine Umhüllungsmasse (30) eingebettet ist.

7. Verfahren zur Herstellung einer oberflächenmontierbaren Lumineszenz- und/oder Photo-Diode, nach einem der vorhergehenden Ansprüche, mit den Verfahrensschritten:
- Bereitstellen eines Leiterrahmens aus einer biegsamen Mehrlagenschicht, die eine Metallfolie und eine auf der Metallfolie angeordnete und mit dieser verbundene Kunststofffolie umfaßt, wobei die Metallfolie einen ersten und einen zweiten Chipanschlußbereich umfaßt und die Kunststofffolie in den auf diesen Chipanschlußbereichen angeordneten Bereichen Aussparungen aufweist;
- Bereitstellen eines Halbleiterchips, der einen aktiven, strahlungsemittierenden Bereich enthält und eine erste und zweite Kontaktfläche aufweist;
- Montieren des Halbleiterchips mit der ersten Kontaktfläche auf den ersten Chipanschlußbereich des Leiterrahmens in der ersten Aussparung der Kunststofffolie;
- Verbinden der zweiten Kontaktfläche mit dem zweiten Chipanschlußbereich des Leiterrahmens mittels eines Bondrahts, der durch die auf dem zweiten Chipanschlussbereich angeordnete zweite Aussparung der Kunststofffolie zum zweiten Chipanschlusßbereich geführt ist; und
- Umhüllen des Halbleiterchips mit einem transparenten oder transluzenten Umhüllungsmaterial.

8. Verfahren nach Anspruch 7,
**dadurch gekennzeichnet, daß** der Schritt des Bereitstellens eines Leiterrahmens das Bereitstellen und Stanzen einer dünnen Metallfolie, um den ersten und zweiten Chipanschlußbereich zu definieren, umfaßt.

9. Verfahren nach Anspruch 7 oder 8,
**dadurch gekennzeichnet, daß** der Schritt des Bereitstellens eines Leiterrahmens das Bereitstellen und Stanzen einer dünnen Kunststofffolie, um Aussparungen zum elektrischen Anschluß des Halbleiterchips zu definieren, umfaßt.

10. Verfahren nach einem der Ansprüche 7 bis 9,
**dadurch gekennzeichnet, daß** der Schritt des Bereitstellens eines Leiterrahmens das Verkleben der beiden Folien umfaßt.

11. Verfahren nach einem der Ansprüche 7 bis 10,
**dadurch gekennzeichnet, daß**
bei dem Schritt des Umhüllens das Umhüllungsmaterial auf die Kunststofffolie der Mehrlagenschicht gespritzt wird.

12. Verfahren nach einem der Ansprüche 7 bis 11,
**dadurch gekennzeichnet, daß**
bei dem Schritt des Umhüllens ein Anspritzkanal durch eine Mehrzahl von auf der Mehrlagenschicht angeordnete Chips geführt wird.

13. Verfahren nach einem der Ansprüche 7 bis 12,
**dadurch gekennzeichnet, daß**
der erste und zweite Chipanschlußbereich des Leiterrahmens bei den Schritten des Montieren des Halbleiterchips, des Verbindens der zweiten Kontaktfläche und des Umhüllens des Halbleiterchips kurzgeschlossen und geerdet werden.

14. Verfahren nach einem der Ansprüche 7 bis 13,
**dadurch gekennzeichnet, daß**
eine Mehrzahl von auf der Mehrlagenschicht angeordneter Chips nach dem Schritt des Umhüllens auf Funktionsfähigkeit getestet werden, und daß dazu die einzelnen Chips bei Erhalt ihrer mechanische Einbindung elektrisch getrennt werden.

## Claims

1. Surface-mountable luminescent diode and/or photodiode with a chip package which has a leadframe (16), the leadframe (16) being formed by a flexible multilayered sheet (12, 14) which comprises a metal foil (12) and a plastic film (14) arranged on the metal foil and connected to it,
and a semiconductor chip (22) which is arranged on the leadframe (16) and is in electrical contact with it and which contains an active, radiation-emitting and/or radiation-receiving region,
- the metal foil (12) comprising a first chip connection region (18) and a second chip connection region (20), **characterized in that** the plastic film has clearances (34, 36) in the regions arranged on these chip connection regions (18, 20), and
- the semiconductor chip (22) being arranged with a first contact area (24) in a first clearance (34) of the plastic film (14) on the first chip connection region (18), and being connected with a second contact area (26) to the second chip connection region (20) by means of a bonding wire (28) which is led to the second chip connection region (20) through the second clearance (36) of the plastic film (14), which clearance is arranged on the second chip connection region (20).

2. Surface-mountable luminescent diode and/or photodiode according to Claim 1, **characterized in that** the plastic film (14) is adhesively bonded to the metal foil (12).

3. Surface-mountable luminescent diode and/or photodiode according to Claim 1 or 2, **characterized in that** the thickness of the metal foil (12) is between 30 µm and 60 µm inclusive.

4. Surface-mountable luminescent diode and/or photodiode according to one of the preceding claims, **characterized in that** the plastic film is formed by an epoxy resin film (14).

5. Surface-mountable luminescent diode and/or photodiode according to one of the preceding claims, **characterized in that** the thickness of the plastic film (14) is between 30 µm and 60 µm inclusive.

6. Surface-mountable luminescent diode and/or photodiode according to one of the preceding claims, **characterized in that** the semiconductor chip (22) is embedded in an encapsulating composition (30).

7. Method for producing a surface-mountable luminescent diode and/or photodiode, according to one of the preceding claims, with the method steps of:
- providing a leadframe from a flexible multilayered sheet which comprises a metal foil and a plastic film arranged on the metal foil and connected to it, the metal foil having a first chip connection region and a second chip connection region, and the plastic film having clearances in the regions arranged on these chip connection regions;
- providing a semiconductor chip, which contains an active, radiation-emitting region and has a first contact area and a second contact area;
- mounting the semiconductor chip with the first contact area on the first chip connection region of the leadframe in the first clearance of the plastic film;
- connecting the second contact area to the second chip connection region of the leadframe by means of a bonding wire which is led to the second chip connection region through the second clearance of the plastic film, which clearacnce is arranged on the second chip connection region; and
- encapsulating the semiconductor chip with a transparent or translucent encapsulating material.

8. Method according to Claim 7, **characterized in that** the step of providing a leadframe comprises providing and punching a thin metal foil in order to define the first and second chip connection regions.

9. Method according to Claim 7 or 8, **characterized in that** the step of providing a leadframe comprises providing and punching a thin plastic film in order to define clearances for the electrical connection of the semiconductor chip.

10. Method according to one of Claims 7 to 9, **characterized in that** the step of providing a leadframe comprises the adhesive bonding of the foil and the film.

11. Method according to one of Claims 7 to 10, **characterized in that**, in the encapsulating step, the encapsulating material is deposited on the plastic film of the multilayered sheet by moulding.

12. Method according to one of Claims 7 to 11, **characterized in that**, in the encapsulating step, a runner is led through a plurality of chips arranged on the multilayered sheet.

13. Method according to one of Claims 7 to 12, **characterized in that** the first and second chip connection regions of the leadframe are short-circuited and grounded in the steps of mounting the semiconductor chip, connecting the second contact area and encapsulating the semiconductor chip.

14. Method according to one of Claims 7 to 13, **characterized in that** a pluralty of chips arranged on the multilayered sheet are tested for their functional capability after the encapsulating step and **in that**, for this purpose, the individual chips are electrically isolated when they are mechanically incorporated.

## Revendications

1. Diode luminescente et/ou photodiode qui peut être montée en surface, comprenant un boîtier de puce qui a un cadre (16) conducteur formé d'une couche (12, 14) souple à plusieurs strates, qui comprend une feuille (12) métallique et une feuille (14) en matière plastique disposée sur la feuille métallique et reliée à celle-ci, et une puce (22) à semi-conducteurs qui est disposée sur le cadre (16) conducteur, qui est en contact électrique avec lui et qui comporte une partie active émettant du rayonnement et/ou recevant du rayonnement, dans laquelle la feuille (12) métallique comprend une première partie (18) de borne de puce et une deuxième partie (20) de borne de puce,
**caractérisée en ce que**
- la feuille en matière plastique a des évidements (34, 36) dans les parties disposées sur ces parties (18, 20) de borne de puce, et
- la puce (22) à semi-conducteurs est disposée, par une première surface (24) de contact dans un premier évidement (34) de la feuille (14) en matière plastique, sur la première partie (18) de borne de puce et par une deuxième surface (26) de contact est reliée à la deuxième partie (20) de borne de puce au moyen d'un fil (28) de liaison qui va à la deuxième partie (20) de borne de puce en passant par le deuxième évidement (36) de la feuille (14) en matière plastique, qui est disposé sur la deuxième partie (20) de borne de puce.

2. Diode luminescente et/ou photodiode qui peut être montée en surface suivant la revendication 1,
**caractérisée en ce que** la feuille (14) en matière plastique est collée à la feuille (12) métallique.

3. Diode luminescente et/ou photodiode qui peut être montée en surface suivant la revendication 1 ou 2,
**caractérisée en ce que** l'épaisseur de la feuille (12) métallique est comprise entre 30 µm et 60 µm, y compris ces deux valeurs.

4. Diode luminescente et/ou photodiode qui peut être montée en surface suivant l'une des revendications précédentes,
**caractérisée en ce que** la feuille de matière plastique est formée d'une feuille (14) de résine époxyde.

5. Diode luminescente et/ou photodiode qui peut être montée en surface suivant l'une des revendications précédentes,
**caractérisée en ce que** l'épaisseur de la feuille (14) en matière plastique est comprise entre 30 µm et 60 µm, y compris ces deux valeurs.

6. Diode luminescente et/ou photodiode qui peut être montée en surface suivant l'une des revendications précédentes,
**caractérisée en ce que** la puce (22) à semi-conducteurs est incorporée dans une masse d'enrobage.

7. Procédé de production d'une diode luminescente et/ou d'une photodiode qui peut être montée en surface suivant l'une des revendications précédentes, comprenant les stades de procédé, dans lesquels:
- on se procure un cadre conducteur en une couche souple à plusieurs strates, qui comprend une feuille métallique et une feuille en matière plastique disposée sur la feuille métallique et qui lui est reliée, la feuille métallique comprenant une première et une deuxième partie de borne de puce et la feuille en matière plastique ayant des évidements dans les parties disposées sur ces parties de borne de puce;
- on se procure une puce à semi-conducteurs qui comporte une partie active émettant du rayonnement et qui a une première et une deuxième surface de contact ;
- on monte la puce à semi-conducteurs par la première surface de contact sur la première partie de borne de puce du cadre conducteur dans le premier évidement de la feuille en matière plastique ;
- on relie la deuxième surface de contact à la deuxième partie de borne de puce du cadre conducteur au moyen d'un fil de liaison qui va à la deuxième partie de borne de puce en passant par le deuxième évidement de la feuille en matière plastique, qui est disposé sur la deuxième partie de borne de puce ; et
- on enrobe la puce à semi-conducteurs d'une matière d'enrobage transparente ou translucide.

8. Procédé suivant la revendication 7,
**caractérisé en ce que** le stade dans lequel on se procure un cadre conducteur comprend le fait de se procurer et d'estamper une mince feuille métallique pour définir la première et la deuxième parties de borne de puce.

9. Procédé suivant la revendication 7 ou 8,
**caractérisé en ce que** le stade dans lequel on se procure un cadre conducteur comprend le fait de se procurer et d'estamper une mince feuille en matière plastique pour définir des évidements pour le raccordement électrique de la puce à semi-conducteurs.

10. Procédé suivant l'une des revendications 7 à 9,
**caractérisé en ce que** le stade dans lequel on se procure un cadre conducteur comprend le collage des deux feuilles.

11. Procédé suivant l'une des revendications 7 à 10,
**caractérisé en ce que**, dans le stade de l'enrobage, on projette la matière d'enrobage sur la feuille en matière plastique de la couche à plusieurs strates.

12. Procédé suivant l'une des revendications 7 à 11,
**caractérisé en ce que**, dans le stade de l'enrobage, on fait passer un canal de projection à travers une multiplicité de puces disposées sur la couche à plusieurs stades.

13. Procédé suivant l'une des revendications 7 à 12,
**caractérisé en ce que** l'on court-circuite et on met à la terre la première et la deuxième partie de borne de puce du cadre conducteur dans le stade du montage de la puce à semi-conducteurs de la liaison de la deuxième surface de contact et de l'enrobage de la puce à semi-conducteurs.

14. Procédé suivant l'une des revendications 7 à 13,
**caractérisé en ce que** l'on teste l'aptitude à fonctionner d'une multiplicité de puces disposées sur la couche à plusieurs strates après le stade de l'enrobage et **en ce que** l'on sépare, à cet effet, électriquement les diverses puces lorsque leur liaison mécanique est obtenue.
